# EUROPÄISCHE PATENTSCHRIFT

(11) **EP 1 520 293 B1**
(45) Veröffentlichungstag und Bekanntmachung des Hinweises auf die Patenterteilung: **13.12.2006**
(21) Anmeldenummer: 03762412.9
(22) Anmeldetag: 21.06.2003
(51) Int. Cl.: H01L 21/28, H01L 21/336, H01L 29/78

(54) **VERFAHREN ZUR HERSTELLUNG EINES KURZKANAL-FELDEFFEKTTRANSISTORS**
METHOD FOR THE PRODUCTION OF A SHORT CHANNEL FIELD EFFECT TRANSISTOR
PROCEDE DE PRODUCTION D'UN TRANSISTOR A EFFET DE CHAMP A CANAL COURT

(30) Priorität: 08.07.2002 DE 10230696
(43) Veröffentlichungstag der Anmeldung: 06.04.2005
(73) Patentinhaber: Infineon Technologies AG, 81669 München (DE)
(72) Erfinder: FEHLHABER, Rodger, 80687 München (DE); TEWS, Helmut, 81549 München (DE)
(74) Vertreter: Kindermann, Peter
(86) Internationale Anmeldenummer: PCT/DE2003/002072
(87) Internationale Veröffentlichungsnummer: WO 2004/006314

(56) Entgegenhaltungen:
- US-A- 5 391 510
- US-A- 5 397 909
- US-A- 6 008 096
- ABBAS S A ET AL: "FORMATION OF SUB-MICRON PATTERNS WITH NEGLIGIBLE TOLERANCE" IBM TECHNICAL DISCLOSURE BULLETIN, IBM CORP. NEW YORK, US, Bd. 26, Nr. 6, 1. November 1983 (1983-11-01), Seiten 2732-2738, XP000648245 ISSN: 0018-8689
- PATENT ABSTRACTS OF JAPAN vol. 014, no. 229 (E-0928), 15. Mai 1990 (1990-05-15) & JP 02 060131 A (MATSUSHITA ELECTRIC WORKS LTD), 28. Februar 1990 (1990-02-28)

## Beschreibung

Die Erfindung bezieht sich auf ein Verfahren zur Herstellung eines Kurzkanal-Feldeffekttransistors und insbesondere auf ein Verfahren zur Herstellung von CMOS-Transistoren mit Kanallängen unterhalb von 100 Nanometer und minimalen Schwankungen der kritischen Abmessungen. Ein Verfahren zur Herstellung eines Feldeffekt-transistors durch Verwendung der Seitenwand-Spacern als Maske für den Gate-Stapel ist aus Dokument US-A-6008096 bekannt.

Mit der fortschreitenden Integrationsdichte von Halbleiterschaltungen verringern sich zunehmend auch die kritischen Abmessungen bzw. kleinsten Strukturgrößen von Halbleiterbauelementen. Hierbei kommt insbesondere der Kontrolle bzw. Einstellbarkeit einer Gatelänge in sogenannten Feldeffekttransistoren (FETs) eine besondere Bedeutung zu, da hierdurch die elektrischen Eigenschaften wesentlich beeinflusst werden. Ohne den Einsatz derartiger sogenannter Kurzkanal-Transistoren ist eine weitergehende Integrationsdichte und Schaltungskomplexität nicht zu realisieren.

Mit der zunehmenden Verringerung der Kanallänge verringert sich üblicherweise jedoch auch eine Breite einer zugehörigen Gate-Steuerschicht (Gate-Stapel), wodurch sich wesentliche Leitfähigkeitsprobleme und somit Ansteuer- bzw. Geschwindigkeitsprobleme ergeben. Zur Beseitigung derartiger Leitfähigkeitsprobleme wurden in letzter Zeit sogenannte Replacement-Gate-Verfahren eingesetzt, wobei eine üblicherweise aus Polysilizium bestehende Gate-Opferschicht auf dem Gateoxid abgeschieden wird, anschließend mittels Lithographie und mittels Trockenätzen strukturiert wird, und nach dem Ausbilden von Source-/Draingebieten entfernt und die entstehende Gate-Aussparung mit hochleitenden Materialien zur Realisierung des eigentlichen Gates aufgefüllt wird.

Bei der Entwicklung von geeigneten Lithographieverfahren zur Herstellung sehr feiner Gate-Strukturen in einem Sub-100-Nanometer-Bereich ergeben sich jedoch außerordentlich große Probleme, die insbesondere aus der sogenannten Resistchemie, der Maskenherstellung und der Komplexität des Lithographiesystems resultieren.

Bei der Weiterentwicklung der optischen Lithographie zur Herstellung von sehr feinen Strukturen im Bereich von 100 Nanometer wurde beispielsweise die sogenannte 157 Nanometer-Lithographie erreicht. Diese Lithographieverfahren benötigen hierbei neuartige Resistmaterialien, wobei trotz intensivster Bemühungen bisher kein Resist gefunden wurde, der vollständig die technischen Anforderungen hinsichtlich derartig kleiner Strukturen erfüllt. Darüber hinaus sind neben diesen neuen Materialien auch neue Verfahren zur Maskenherstellung notwendig, wobei deren Entwicklung wiederum sehr kostenintensiv ist. Es ergeben sich daher sehr kostenintensive und schwer handhabbare Lithographiesysteme.

Als Alternative zu derartigen herkömmlichen optischen Lithographieverfahren wurden daher sogenannte sublithographische Verfahren eingeführt. Bei diesen Verfahren wird z.B. mit dem herkömmlichen Fotoresist eine Struktur auf einer Hilfsschicht abgebildet, diese Hilfsschicht anisotrop geätzt, die Resistmaske entfernt, und anschließend mit einem isotropen Ätzverfahren die Hilfsschicht von allen Seiten geätzt und damit verkleinert. Diese verkleinerte Struktur in der Hilfsschicht bildet dann die gewünschte sublithographische Maske.

Nachteilig bei derartigen herkömmlichen Verfahren sind jedoch die Schwankungen der kritischen Abmessungen CD (Critical Dimension) der sublithographischen Maske, die im Wesentlichen von verwendeten Resistmaterialien, der Resistchemie, dem anisotropen Ätzprozess und dem anschließenden isotropen Ätzprozess herrühren. Jeder dieser Prozesse erhöht die Variation der kritischen Abmessung CD. Diese Schwankungen der kritischen Abmessung CD (heute typisch 12 Nanometer) stellen mit abnehmender Gatelänge < 100nm ein immer stärker werdendes Problem dar, da es sehr schwierig ist, gleichzeitig die Forderungen nach kleinerer Gatelänge und proportional verringerter CD Schwankung zu erfüllen. Im Bereich unterhalb von 100 nm wirken sich derartige Schwankungen stark auf die elektrischen Eigenschaften der einzelnen Transistoren und der Gesamtschaltung aus.

Der Erfindung liegt daher die Aufgabe zu Grunde, ein Verfahren zur Herstellung eines Kurzkanal-Feldeffekttransistors zu schaffen, wobei mit minimalem Aufwand Schwankungen der kritischen Abmessungen bzw. der Kanallängen stark verringert und anisotrope Ätzverfahren auf ein Minimum reduziert sind.

Erfindungsgemäß wird diese Aufgabe durch die Maßnahmen des Patentanspruchs 1 gelöst.

Insbesondere auf Grund der Durchführung einer chemischen Umwandlung von zumindest den Seitenwänden einer ersten Maske zum Ausbilden einer sublithographischen Maskenschicht und der weiteren Verwendung dieser chemisch umgewandelten Maskenschicht als Gate-Opferschicht können bei Reduzierung von unerwünschten anisotropen Ätzverfahren und einer weitgehenden Vereinfachung des Gesamtprozesses Schwankungen der kritischen Abmessungen bzw. der Kanallängen stark verringert werden, da die chemische Umwandlung nahezu 100% konform zu einer Oberfläche möglich ist und die umgewandelte Gate-Opferschicht mit herkömmlichen isotropen Ätzverfahren entfernt werden kann.

Zusätzlich kann eine Schutzschicht für die sublithographische Maskenschicht ausgebildet werden, wobei die in nachfolgenden lithographischen Verfahren durchgeführten Ätzschritte das Auftreten von zusätzlichen Schwankungen der kritischen Abmessung zuverlässig verhindern.

Vorzugsweise wird als erste Maskenschicht eine Polysiliziumschicht verwendet und als chemische Umwandlung eine nasse Oxidation mit H₂ und O₂ durchgeführt, wodurch man bei Einsatz von Standardmaterialien und Standardverfahren eine sehr geringe Schwankung der Kanallänge des Feldeffekttransistors erhält.

Ferner kann eine weitere Schutzschicht an der Oberfläche des Halbleitersubstrats ausgebildet werden, die als zusätzliche Ätzstoppschicht und Streuschicht bei einer nachfolgend durchgeführten Implantation verwendet werden kann. Sowohl die elektrischen Eigenschaften als auch die Ätzgenauigkeit lässt sich dadurch weiter verbessern.

Vorzugsweise wird als Opfer-Füllschicht Poly-SiGe abgeschieden und planarisiert, wodurch man eine ausreichende Ätzselektivität gegenüber den weiterhin verwendeten Standardmaterialien des Gatestapels erhält.

Ferner kann nach dem Entfernen der sublithographischen Gate-Opferschicht eine Spacer-Zusatzschicht ausgebildet werden, wodurch sich die Isolationseigenschaften für das Gate bzw. die Steuerschicht weiter verbessern lassen.

Zum Auffüllen der erzeugten Gate-Aussparung wird vorzugsweise ein sogenanntes Damascene-Verfahren verwendet, wodurch sich die sehr schmalen Gräben mit hervorragend leitenden Materialien auffüllen lassen.

Zur Realisierung einer verbesserten Ansteuerbarkeit der Transistoren werden für das Gate-Dielektrikum Materialien mit hoher Dielektrizitätskonstante und für die Steuerschicht Materialien mit hoher elektrischer Leitfähigkeit verwendet.

Vorzugsweise wird zur Realisierung von Anschlussschichten bzw. Kontakten der Source-/Draingebiete ein sogenanntes Silizid-Verfahren (salicide process) durchgeführt, wodurch Kontakte mit hoher Leitfähigkeit selbstjustierend ausgebildet werden können.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

### Es zeigen:

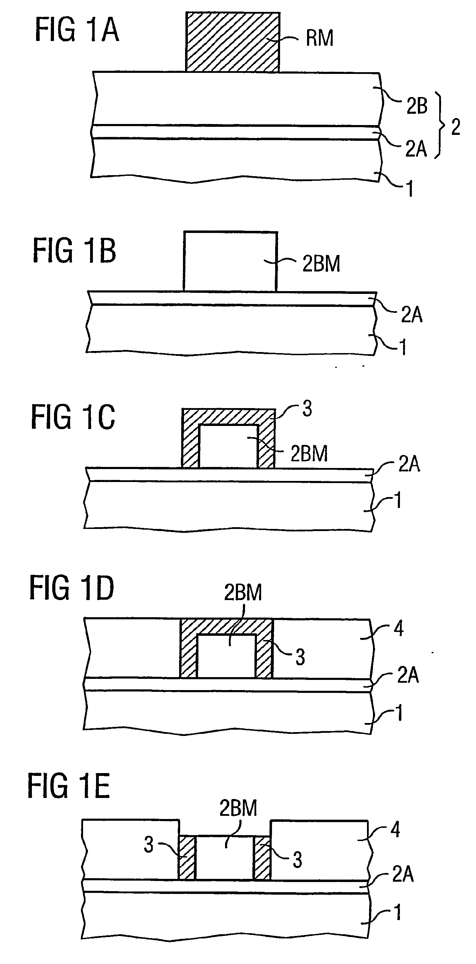

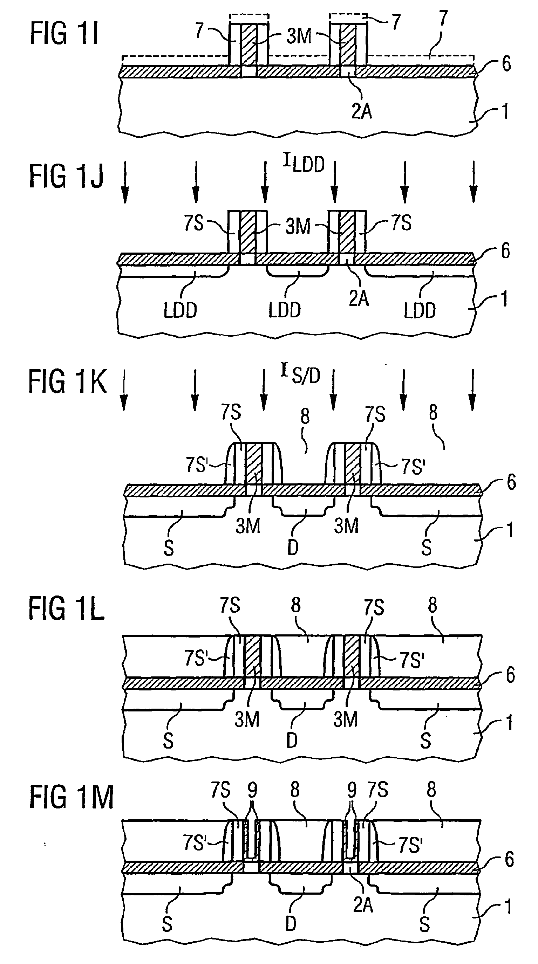

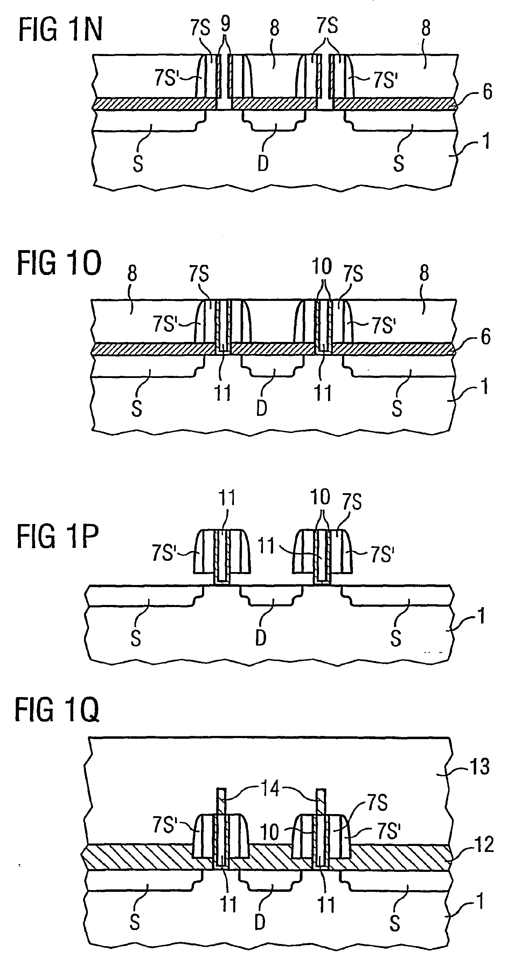

Figuren 1A bis 1P vereinfachte Schnittansichten oder Draufsichten zur Veranschaulichung eines erfindungsgemäßen Verfahrens zur Herstellung eines Kurzkanal-Feldeffekttransistors.

Die Figuren 1A bis 1P zeigen vereinfachte Schnittansichten oder Draufsichten zur Veranschaulichung des erfindungsgemäßen Verfahrens zur Herstellung von Kurzkanal-Feldeffekttransistoren, wie sie beispielsweise in CMOS-Halbleiterschaltungen mit Kanallängen unterhalb von 100 Nanometer verwendet werden kann.

Gemäß Figur 1A wird als Halbleitersubstrat 1 vorzugsweise monokristallines Silizium verwendet, wobei jedoch auch beliebig andere Halbleitersubstrate wie z.B. SOI, Ge oder III-V-Halbleiter verwendet werden können.

An der Oberfläche des Halbleitersubstrats 1 wird eine erste Maskenschicht 2 ausgebildet, die beispielsweise als Hartmaskenschicht ein Halbleitermaterial aufweist und vorzugsweise eine ca. 50 bis 100 Nanometer dicke amorphe oder polykristalline Siliziumschicht 2B aufweist. Optional kann die erste Maskenschicht 2 ferner eine Ätzstoppschicht 2A aufweisen, die beispielsweise aus einer ca. 10 Nanometer dicken Siliziumnitridschicht besteht und zur Erhöhung einer Genauigkeit bei späteren Strukturierungsschritten verwendet werden kann.

Zum fotolithographischen Strukturieren der ersten Maskenschicht 2 können eine Vielzahl von Lithographieverfahren verwendet werden, wobei gemäß Figur 1A zunächst eine erste Resistschicht an der Oberfläche der Maskenschicht 2 ausgebildet, anschließend belichtet und entwickelt und schließlich strukturiert wird, wodurch man eine erste Resistmaske RM erhält.

Gemäß Figur 1B wird anschließend unter Verwendung der Resistmaske RM die Maskenschicht 2 strukturiert, wobei bei Verwendung der optionalen Ätzstoppschicht 2A lediglich die darüber liegende Hartmaskenschicht 2B zum Ausbilden einer ersten Maske 2BM verwendet wird. Das Verfahren zum Durchführen einer derartigen lithographischen Strukturierung entspricht einem herkömmlichen lithographischen Verfahren, weshalb auf eine detaillierte Beschreibung nachfolgend verzichtet wird.

Die in Figur 1B dargestellte erste Maske 2BM dient beispielsweise zur Festlegung eines Abstands von zwei benachbarten Gates in einer CMOS-Schaltung, wobei die Abmessungen der ersten Resistmaske RM und somit auch der ersten Maske 2BM wesentlich größer sind als die gewünschte Gatelänge bzw. die eine auszubildende sublithographische Gate-Opferschicht. In einer 70 Nanometer-Technologie besitzt die erste Maske 2BM beispielsweise eine Abmessung (Breite) von zum Beispiel 160 Nanometer. Ein derartiger Lithographieschritt kann daher mittels herkömmlicher MUV-Lithographie (Mid Ultra Violet) realisiert werden, wobei die dabei auftretende Resist-Seitenwand-Rauhigkeit für das nachfolgend beschriebene Verfahren unbedeutend ist, da es keinen Einfluss auf die endgültige Gatelänge bzw. die sublithographische Gate-Opferschicht besitzt.

Gemäß Figur 1C wird nunmehr eine chemische Umwandlung der Oberfläche und zumindest der Seitenwände der ersten Maske 2BM zum konformalen Ausbilden einer sublithographischen Maskenschicht 3 durchgeführt. Genauer gesagt wird beispielsweise eine nasse Oxidation mittels O₂ und H₂ für ca. 20 Minuten bei einer Temperatur von 900 Grad Celsius durchgeführt, wodurch die Polysilizium-Seitenwände bzw. die Oberfläche der ersten Maske 2BM bis zu einer Dicke von beispielweise 30 Nanometer oxidiert wird. Diese chemische Umwandlung erfolgt hierbei nahezu 100% konform zur Oberfläche der ersten Maske 2BM, weshalb die Dicke der derart ausgebildeten sublithographischen Maskenschicht 3 an jedem Ort nahezu identisch ist und kaum Schwankungen aufweist.

Insbesondere werden durch diese chemische Umwandlung der ersten Maske 2BM Dickenschwankungen bzw. Schwankungen der kritischen Abmessung CD zuverlässig vermieden, die eine Verschlechterung der elektrischen Eigenschaften beispielsweise in Halbleiterschaltungen bewirken.

Da ferner eine derartige chemische Umwandlung wie z.B. eine Oxidation sehr genau gesteuert werden kann, erhält man problemlos eine Dickenkontrolle bzw. Einstellbarkeit der Dicke von 5% oder besser. Die Dicke der umgewandelten Oberflächen- bzw. Seitenwandschicht kann demzufolge in einem Bereich von 5 bis 50 Nanometer sehr genau anhand der Prozessparameter wie beispielweise einer Temperatur und einer Gaszusammensetzung festgelegt werden.

Eine Übergangsrauhigkeit von der ersten Maske bzw. der Polysiliziumschicht 2BM zur sublithographischen Maskenschicht bzw. dem Siliziumoxid 3 kann hierbei durch die Verwendung einer zusätzlichen amorphen Siliziumabscheidung anstelle einer Polysiliziumabscheidung ebenso verbessert werden wie durch eine vor der chemischen Umwandlung bzw. Oxidation durchgeführte Nitridation.

In diesem Zusammenhang ist es von Bedeutung, dass eine Rauhigkeit bzw. eine Dickenschwankung der Resist-Seitenwände und damit der ersten Maske 2BM die Dicke der chemisch umgewandelten sublithographischen Maskenschicht 3 bzw. des Siliziumdioxids nicht beeinflusst. Während in herkömmlichen Lithographieverfahren die beiden Seitenwände der Resistmaske voneinander unabhängige Rauhigkeiten bzw. unabhängige Schwankungen aufweisen und diese Rauhigkeiten zu lokalen Schwankungen in der kritischen Abmessungen CD führen, ist die Schichtdicke der chemisch umgewandelten Maskenschicht 3 unabhängig von derartigen Resist-Rauhigkeiten und/oder Abscheidungs-Ungleichmäßigkeiten. Demzufolge führen Resist-Rauhigkeiten bzw. Schwankungen lediglich zu Positionierfehlern eines jeweiligen Transistors (Gates), jedoch nicht zu einer Variation einer jeweiligen Gatelänge und somit Kanallänge. Darüber hinaus sind insbesondere in einem Oxidationsverfahren die Oxiddicken in erster Linie unabhängig von einer Dichte von jeweiligen Polystrukturen wie z.B. isolierten Strukturen oder dicht beieinanderstehenden Strukturen, die jeweils gleiche Oxiddicken aufweisen.

Gemäß einer nicht dargestellten vereinfachten Ausführungsform kann nach der chemischen Umwandlung zum Ausbilden der sublithographischen Maskenschicht 3 unmittelbar ein lithographisches Strukturieren zum Entfernen der ersten Maske 2BM sowie eventuell nicht benötigter Teile der sublithographischen Maskenschicht 3 erfolgen, wodurch man bereits eine sublithographische Gate-Opferschicht mit sehr geringen Schwankungen der kritischen Abmessungen CD erhält.

Zur weiteren Verbesserung bzw. Verringerung der Schwankungen der kritischen Abmessungen CD (Critical Dimension) kann jedoch gemäß Figur 1D optional eine Schutzschicht 4 für die sublithographische Maskenschicht vor dem lithographischen Strukturieren ausgebildet werden. Genauer gesagt kann beispielsweise eine Polysiliziumabscheidung zum ganzflächigen Ausbilden der Schutzschicht 4 über der sublithographischen Maskenschicht 3 durchgeführt werden, wobei anschließend beispielsweise mittels eines CMP-Verfahrens (Chemical Mechanical Polishing) die Schutzschicht 4 bis zur Maskenschicht 3 wieder entfernt wird. Die Maskenschicht 3 kann hierbei als Stoppschicht dienen.

Gemäß Figur 1E werden in einem nachfolgenden Ätzschritt beispielsweise die freigelegten Oberflächenbereiche der Maskenschicht 3 entfernt, wobei vorzugsweise ein Oxidätzen zum Entfernen des freigelegten Topoxids durchgeführt wird. Hierbei können herkömmliche nasschemische Ätzverfahren verwendet werden, wobei die Ätztiefe gleich der Oxiddicke bzw. der Dicke der Maskenschicht 3 ist.

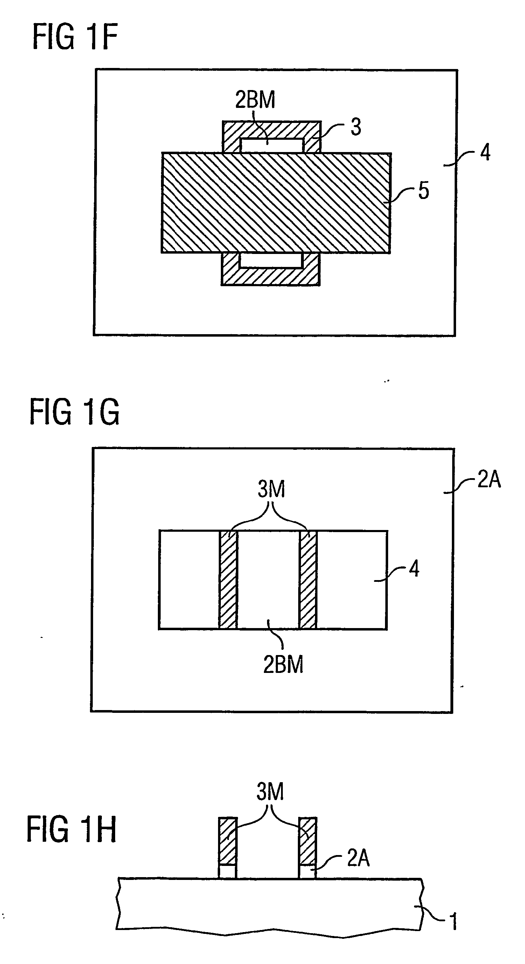

In einem nachfolgenden Schritt wird gemäß Figur 1F zum lithographischen Strukturieren der sublithographischen Maskenschicht 3 eine zweite Resistmaske 5 als Ätzmaske verwendet und ein nasschemisches oder trockenchemisches Ätzen der freiliegenden Poly-Silizium- und Oxidbereiche selektiv zur Ätzstoppschicht 2A durchgeführt.

Gemäß der in Figur 1F dargestellten Draufsicht werden demzufolge die freiliegenden Bereiche der ersten Maske 2BM der Maskenschicht 3 und der Schutzschicht 4 bis zur Ätzstoppschicht 2A entfernt, wodurch man nach Entfernen der zweiten Resistmaske 5 die in Figur 1G dargestellte Draufsicht erhält. Bei entsprechender Wahl des Halbleitersubstrats 1 und der verwendeten Ätzverfahren kann die optionale Ätzstoppschicht 2A auch entfallen, wobei die freiliegenden Schichten lediglich bis zum Halbleitersubstrat 1 entfernt werden.

Gemäß Figur 1H, die wiederum eine vereinfachte Schnittansicht darstellt, werden nachfolgend das Polysilizium der ersten Maske 2BM und der Schutzschicht 4 selektiv zur Ätzstoppschicht bzw. Siliziumnitridschicht 2A entfernt und anschließend die Ätzstoppschicht 2A weggeätzt, wodurch man die für den nachfolgenden modifizierten Gate-Replacement-Prozess notwendige sublithographische Gate-Opferschicht 3M, welche vorzugsweise aus einem Oxid besteht, auf dem Halbleitersubstrat 1 erhält.

Somit lassen sich sehr schmale (z.B. 30 Nanometer breite) sublithographische Gate-Opferschichten 3M mit sehr geringen Schwankungen der kritischen Abmessungen CD realisieren. Der Abstand von zwei sublithographischen Gate-Opferschichten 3M entspricht hierbei der Breite der lithographischen Maske RM. Im Vergleich zu herkömmlichen Spacertechniken ist eine Kontrolle bzw. Herstellbarkeit der kritischen Abmessungen sehr viel präziser, wodurch sich sogar sublithographische Gate-Opferschichten mit einer Strukturbreite von kleiner 10 bis 20 Nanometer realisieren lassen.

Gemäß Figur 1I kann optional eine weitere Schutzschicht 6 an der Oberfläche des Halbleitersubstrats 1 ausgebildet werden, die im Wesentlichen eine Schutzschicht und/oder eine Streuschicht für beispielsweise eine nachfolgende Implantation darstellt. Diese weitere Schutzschicht 6 kann jedoch ebenfalls wie die optional eingeführte Ätzstoppschicht 2A auch entfallen, wobei eine entsprechende Ätzselektivität bzw. Auswahl von Materialien insbesondere für das Halbleitersubstrat 1 notwendig ist.

Gemäß Figur 1I wird somit unmittelbar auf dem Halbleitersubstrat 1 oder auf der optional vorliegenden weiteren Schutzschicht 6 eine Spacer-Schicht 7 mit herkömmlicher Spacertechnologie beispielsweise als Siliziumnitrid-Schicht konform abgeschieden und anschließend anisotrop geätzt, wodurch man die in Figur 1J dargestellte Spacerstruktur 7S an den Seitenwänden der sublithographischen Gate-Opferschichten 3M erhält.

Ferner werden gemäß Figur 1J Anschlussgebiete LDD für später auszubildende Source-/Draingebiete im Halbleitersubstrat 1 vorzugsweise unter Durchführung einer Ionenimplantation I_{LDD} und Verwendung der Spacer 7S und der Gate-Opferschicht 3M als Maske selbstjustierend ausgebildet. Bei Vorliegen der weiteren beispielsweise aus SiO₂ bestehenden Schutzschicht 6 dient diese in diesem Schritt als Streuschicht zur Verbesserung eines Dotierprofils im Halbleitersubstrat 1. Nach Herstellen einer zweiten Spacerschicht bzw. eines zweiten Spacers 7S' analog zu Spacer 7S wird gemäß Figur 1K dann selbstjustiert eine Implantation I_{S/D} zur Ausbildung von Sourcegebiet S und Draingebiet D durchgeführt. Zur Verbesserung der elektrischen Eigenschaften kann nachfolgend eine Temperaturbehandlung durchgeführt werden, mit der eine Ausheilung der bei der Ionenimplantation entstandenen Schädigungen realisiert wird.

Optional zum in den Figuren 1A bis 1J dargestellten Verfahrensablauf kann zu diesem Zeitpunkt auch eine Kontaktierung der Source-/Draingebiete S und D erfolgen, wobei vorzugsweise ein Silizid-Verfahren (salicide process) angewendet wird. Bei Anwesenheit der weiteren Schutzschicht 6 muss diese selbstverständlich vorher entfernt werden.

Gemäß dem vorliegenden bevorzugten Ausführungsbeispiel erfolgt jedoch diese Kontaktierung zu einem späteren Zeitpunkt, weshalb gemäß Figur 1L zunächst eine Opfer-Füllschicht 8 zum Einbetten der sublithographischen Gate-Opferschicht 3M und der Spacer 7S und 7S' durchgeführt wird. Genauer gesagt wird hierbei ein zu einem später ausgebildeten Gatestapel selektiv ätzbares Material als Opfer-Füllschicht 8 abgeschieden und beispielsweise mittels eines CMP-Verfahrens (Chemical Mechanical Polishing) planarisiert, wobei insbesondere für die in der Silizium-Halbleiterfertigung verwendeten Standardmaterialien vorzugsweise Poly-SiGe als Opfer-Füllschicht verwendet wird. Neben diesem Poly-SiGe-Füllmaterial können selbstverständlich auch andere Materialien als Opfer-Füllschicht verwendet werden, sofern sie eine ausreichend gute ÄtzSelektivität zum fertigen Gatestapel aufweisen.

Gemäß Figur 1M wird nunmehr zum Ausbilden einer jeweiligen Gate-Aussparung die sublithographische Gate-Opferschicht 3M entfernt. Bei Verwendung von in CMOS-Schaltungen üblicherweise eingesetzten NFET- und PFET-Transistoren werden diese Gate-Aussparungen vorzugsweise getrennt voneinander mittels herkömmlicher lithographischer Maskierung freigelegt. Zum Entfernen der Gate-Opferschicht 3M werden vorzugsweise nasschemische Ätzverfahren verwendet, die selektiv zur Opfer-Füllschicht 8 und zu den Spacern 7S und 7S' wirken. Bei Verwendung des vorstehend beschriebenen Poly-SiGe für die Opfer-Füllschicht 8 und einer Siliziumnitrid-Schicht für die Spacer 7S kann demzufolge mittels eines herkömmlichen nasschemischen Oxid-Ätzverfahrens die als Gate-Opferschicht 3M dienende Oxidschicht entfernt werden.

Optional kann gemäß Figur 1M an den Seitenwänden der Spacer 7S und dem Halbleitersubstrat 1 bzw. der Ätzstoppschicht 2A eine Spacer-Zusatzschicht 9 ausgebildet werden, wobei beispielsweise in einem kurzen Oxidationsschritt zur Umwandlung der Nitrid-Oberfläche der Spacer 7S und der Ätzstoppschicht 2A ein Oxid als Spacer-Zusatzschicht 9 ausgebildet wird. Vorzugsweise erfolgt diese Umwandlung der Spacer 7S mit einem Oxidations-Verfahren, wobei atomarer Sauerstoff verwendet wird und eine Oxidschicht 9 mit ca. 1 bis 3 Nanometer ausgebildet werden kann.

Durch diese Spacer-Zusatzschicht 9 erhält man eine weiter verbesserte Isolationsschicht für die später auszubildende Steuerschicht bzw. das Gate, wodurch Ladungsverluste bzw. Leckströme zuverlässig verhindert werden können.

Gemäß Figur 1N wird in einem nachfolgenden Schritt zunächst der Bodenbereich der Zusatzschicht 9 entfernt, wobei beispielsweise eine Oxid-Ätzung mit einem anisotropen Ätzverfahren wie z.B. reaktiven Ionenätzen (RIE, Reactive Ion Etch) durchgeführt wird. Sofern die optional ausgebildete Ätzstoppschicht 2A vorhanden ist, wird diese ferner in einer Nitrid-Ätzung selektiv zum Oxid entfernt und das Halbleitersubstrat 1, welches vorzugsweise aus Silizium besteht, an der Oberfläche in seinem Gate-Bereich freigelegt. Auf diese Weise wird eine Gate-Aussparung bis zum Halbleitersubstrat 1 ausgebildet, in der nachfolgend ein Gate-Dielektrikum und der eigentlich auszubildende Sub-100 Nanometer-Gatestapel erzeugt wird.

Vorzugsweise wird zur Realisierung dieses Gatestapels bzw. zum Auffüllen der Gate-Aussparung ein sogenanntes Damascene-Verfahren verwendet, wie es bei der Herstellung von Leiterbahnen bzw. Metallisierungsebenen verwendet wird. Hierbei können Diffusionsbarrierenschichten und/oder Keimschichten als Gate-Dielektrika ausgebildet werden, wodurch ein nachfolgendes Aufwachsen von metallischen Schichten wie z.B. einer Cu-Schicht ermöglicht bzw. vereinfacht wird. Zum Einebnen dieser Grabenfüllschichten wird beispielsweise die oberhalb des Grabens verbleibende Schichtenfolge mittels eines CMP-Verfahrens (Chemical Mechanical Polishing) entfernt und kontaktiert.

Auf diese Weise können auch sehr fein strukturierte Gate-Aussparungen im Sub-100 Nanometer-Bereich zuverlässig aufgefüllt werden und üblicherweise auftretene Korngrößen-, Elektromigrations- und Leitfähigkeitsprobleme innerhalb der Füllschichten zuverlässig verhindert werden.

Zur Realisierung von Gate-Isolationsschichten werden gemäß Figur 10 vorzugsweise Materialien mit hoher Dielektrizitätskonstante bzw. sogenannte high-k-Materialien an der gesamten Oberfläche der Gate-Aussparung bzw. der Zusatzschicht 9 als Gate-Dielektrikum 10 ausgebildet. Grundsätzlich reicht jedoch auch eine Ausbildung einer derartigen Schicht lediglich an der Bodenoberfläche der Gate-Aussparung aus, wobei beispielweise auch Oxidationsverfahren zum Oxidieren der Oberfläche des Halbleitersubstrats 1 in Betracht kommen. Nach dem Ausbilden des Gate-Dielektrikums 10 wird die verbleibende Gate-Aussparung mit einem elektrisch leitenden Material zur Realisierung einer Steuerschicht 11 bzw. des eigentlichen Gates ausgebildet. Vorzugsweise werden hierbei Materialien mit hoher elektrischer Leitfähigkeit verwendet, wodurch die insbesondere bei Sub-100 Nanometer-Strukturen auftretenden Probleme hinsichtlich einer ausreichenden Leitfähigkeit kompensiert werden können.

Bei der Realisierung von CMOS-Schaltungen können beispielsweise für getrennt voneinander ausgebildete PFET-Transistoren und NFET-Transistoren neben metallischen Materialien wie z.B. TaN, Ir, RuO auch dotierte Halbleitermaterialien verwendet werden. Insbesondere kann für PFET-Transistoren in-situ Bordotiertes Polysilizium verwendet werden, wobei auch eine dünne Schicht aus Bor-dotiertem SiGe gefolgt von Polysilizium hervorragende elektrische Eigenschaften für einen jeweiligen Transistor ermöglichen. Andererseits kann für NFET-Transistoren in-situ Arsen oder Phosphor dotiertes Polysilizium empfohlen werden. Grundsätzlich sei hierbei darauf hingewiesen, dass zur Anpassung der Austrittsarbeiten bzw. zum Festlegen von jeweiligen Schwellwertspannungen der jeweiligen Transistoren entsprechende Materialien verwendet werden, wobei auch ein Mehrschichtaufbau mit einer Schicht zur Anpassung der Austrittsarbeit und einer weiteren Schicht zur Realisierung der benötigten hohen Leitfähigkeit denkbar ist. Abschließend erfolgt eine Planarisierung, wobei das vorstehend beschriebene CMP-Verfahren verwendet wird.

Gemäß Figur 1P wird in einem weiteren Verfahrensschritt nunmehr die Opfer-Füllschicht 8, welche vorzugsweise aus einer SiGe-Füllschicht besteht, selektiv zum Gatestapel bzw. zu den hierbei verwendeten Materialien entfernt, wobei vorzugsweise ein nasschemisches Ätzen durchgeführt wird. Sofern vorhanden, wird zu diesem Zeitpunkt auch die optional vorhandene weitere Schutzschicht 6 entfernt und die Oberfläche des Halbleitersubstrats bzw. der Source-/Draingebiete freigelegt.

Obwohl eine Kontaktierung der Source-/Draingebiete S und D, wie bereits vorstehend beschrieben wurde, auch zu einem früheren Zeitpunkt erfolgen kann wird eine entsprechende Kontaktierung vorzugsweise zu diesem Zeitpunkt durchgeführt, wobei vorzugsweise ein Silizid-Verfahren durchgeführt wird.

Zur weiteren Verbesserung der elektrischen Leitfähigkeiten der Source-/Draingebiete S und D bzw. zur Realisierung von hochleitfähigen Anschlussbereichen kann demzufolge zunächst silizierfähiges Material bzw. eine silizierfähige Metallschicht wie z.B. Cobalt, Nickel oder Platin ganzflächig abgeschieden werden. Anschließend wird eine Umwandlung der kristallinen Oberflächenschicht des Halbleitersubstrats 1 unter Verwendung des silizierfähigen Materials zum Ausbilden von hochleitfähigen Anschlussbereichen 12 durchgeführt, wobei an den nicht im Halbleitermaterial (Silizium) in Berührung stehenden Oberflächen dieses Materials kein Silizid (salicide) ausgebildet wird, sondern das abgeschiedene Material (Metall) bestehen bleibt, weshalb wiederum mittels eines vorzugsweise nasschemischen Ätzverfahrens eine selektive Rückätzung der abgeschiedenen Schicht erfolgen kann. Auf diese Weise kann unter Verwendung von lediglich einer Ätzkammer eine Vielzahl von Strukturierungsschritten zum Ausbilden der Anschlussbereiche durchgeführt werden, weshalb sich die Herstellungskosten verringern.

Bei der Verwendung von Cobalt, Nickel oder Platin ergeben sich selbstjustierte hochleitfähige Anschlussbereiche 12 Cobalt-, Nickel- oder Platin-Silizidschichten.

Falls die oberste Schicht der Gate-Stapel aus poly Si bestehen, kann auch auf den Gate-Stapel eine Silizidschicht 14 ausgebildet werden.

Gemäß Figur 1Q wird abschließend eine Isolierschicht 13 zum Einebnen der Halbleiter-Oberfläche ausgebildet, wobei die zwischen den Gatestapeln liegenden Bereiche vorzugsweise mit Oxid wie z.B. HDP (High Density Plasma Oxid) oder BPSG (Bor-Phosphor-Silikat-Glas) aufgefüllt werden.

Auf diese Weise lassen sich Kurzkanal-Feldeffekttransistoren mit sehr kleiner Gatelänge und sehr geringen Schwankungen der kritischen Abmessungen auf einfache Weise realisieren. Darüber hinaus erlaubt das erfindungsgemäße Verfahren die Verwendung von optimierten Materialien für NFET- und PFET-Gatestapeln. Ferner kann die Anzahl von üblicherweise notwendigen anisotropen Ätzschritten verringert werden.

Die Erfindung wurde anhand einer Polysiliziumschicht für eine Maskenschicht, einer Oxidationsumwandlung der Maskenschicht, einer Nitridschicht als Ätzstoppschicht und einer SiGe-Polyschicht als Opfer-Füllschicht beschrieben. Die Erfindung ist jedoch nicht auf derartige Schichtmaterialien beschränkt, sondern umfasst in gleicher Weise Schichtmaterialien, die ähnliche Eigenschaften aufweisen. Insbesondere kann die Realisierung der vorstehend beschriebenen Oxid-Gate-Opferschicht auch durch eine Oxidation von beispielsweise verschiedenen Hartmaskenschichten oder einer chemischen Umwandlung einer abgeschiedenen Schicht wie z.B. eines abgeschiedenen Oxids oder verschiedener abgeschiedener Schichten realisiert werden.

## Patentansprüche

1. Verfahren zur Herstellung eines Kurzkanal-Feldeffekttransistors mit den Schritten:
a) Vorbereiten eines Halbleitersubstrats (1);
b) Ausbilden einer ersten Maskenschicht (2) an der Oberfläche des Halbleitersubstrats (1);
c) lithographisches Strukturieren der ersten Maskenschicht (2) zum Ausbilden einer ersten Maske (2BM) mit im Wesentlichen senkrechten Seitenwänden;
d) Durchführen einer chemischen Umwandlung von zumindest einer Seitenwand der ersten Maske (2BM) zum Ausbilden einer sublithographischen Maskenschicht (3);
e) lithographisches Strukturieren der sublithographischen Maskenschicht (3) zum Ausbilden einer sublithographischen Gate-Opferschicht (3M);
f) Entfernen der ersten Maske (2BM);
g) Ausbilden von Spacern (7S, 7S') an den Seitenwänden der sublithographischen Gate-Opferschicht (3M);
h) Ausbilden von Anschlußgebieten (LDD) und/oder Source-/Draingebieten (S, D) im Halbleitersubstrat (1);
i) Ausbilden einer Opfer-Füllschicht (8) zum Einbetten der sublithographischen Gate-Opferschicht (3M) und der Spacer (7S);
j) Entfernen der sublithographischen Gate-Opferschicht (3M) zum Ausbilden einer Gate-Aussparung;
k) Ausbilden eines Gate-Dielektrikums (10) in der Gate-Aussparung;
l) Ausbilden einer Steuerschicht (11) in der Gate-Aussparung;
m) Entfernen der Opfer-Füllschicht (8) zum Freilegen der Source-/Draingebiete (S, D);
n) Ausbilden von Anschlussschichten (12) für die Source-/Draingebiete (S, D); und
o) Ausbilden einer Isolierschicht (13) zum Einebnen einer Halbleiter-Oberfläche.

2. Verfahren nach Patentanspruch 1,
**gekennzeichnet durch** die weiteren Schritte:
e1) Ausbilden einer Schutzschicht (4) für die sublithographische Maskenschicht (3) vor dem Schritt e); und
e2) Entfernen der Schutzschicht (4) nach dem Schritt e).

3. Verfahren nach Patentanspruch 2,
**dadurch gekennzeichnet, dass** in Schritt e1) die Schutzschicht (4) ganzflächig über der sublithographischen Maskenschicht (3) ausgebildet und anschließend bis zur sublithographischen Maskenschicht (3) zurückgebildet wird.

4. Verfahren nach einem der Patentansprüche 1 bis 3,
**dadurch gekennzeichnet, dass** in Schritt d) eine konforme Umwandlung der Seitenwände der ersten Maske (2BM) in einem Dickenbereich von 5 bis 50 Nanometer erfolgt.

5. Verfahren nach einem der Patentansprüche 1 bis 4,
**dadurch gekennzeichnet, dass** die erste Maskenschicht (2) ein Halbleitermaterial aufweist und die chemische Umwandlung in Schritt d) eine Oxidation des Halbleitermaterials darstellt.

6. Verfahren nach Patentanspruch 5,
**dadurch gekennzeichnet, dass** in Schritt d) eine nasse Oxidation mit H₂ und O₂ durchgeführt wird.

7. Verfahren nach einem der Patentansprüche 1 bis 6,
**dadurch gekennzeichnet, dass** in den Schritten b) und c)
b1) ein Ausbilden einer ersten Resistschicht an der Oberfläche der Maskenschicht (2);
c1) ein lithographisches Strukturieren der Resistschicht zum Ausbilden einer ersten Resistmaske (RM); und
c2) ein Strukturieren der Maskenschicht (2) unter Verwendung der ersten Resistmaske (RM) erfolgt.

8. Verfahren nach einem der Patentansprüche 1 bis 7,
**dadurch gekennzeichnet, dass** die Maskenschicht (2) eine Ätzstoppschicht (2A) aufweist und in Schritt e) eine zweite Resistmaske (5) als Ätzmaske verwendet wird.

9. Verfahren nach Patentanspruch 8,
**dadurch gekennzeichnet, dass** die erste Maskenschicht (2) eine Polysiliziumschicht (2B) und eine Siliziumnitridschicht (2A) aufweist.

10. Verfahren nach einem der Patentanspruch 1 bis 9,
**dadurch gekennzeichnet, dass** vor Schritt g) eine weitere Schutzschicht (6) an der Oberfläche des Halbleitersubstrats (1) ausgebildet und in Schritt m) diese weitere Schutzschicht (6) wieder entfernt wird.

11. Verfahren nach einem der Patentansprüche 1 bis 10,
**dadurch gekennzeichnet, dass** in Schritt g) eine konforme Si₃N₄-Schicht (7) ausgebildet und anisotrop geätzt wird.

12. Verfahren nach einem der Patentansprüche 1 bis 11,
**dadurch gekennzeichnet, dass** in Schritt h) eine Ionenimplantation (I_{LDD}, I_{S/D}) mit nachfolgender Temperaturbehandlung durchgeführt wird.

13. Verfahren nach einem der Patentansprüche 1 bis 12,
**dadurch gekennzeichnet, dass** der Schritt h) nach dem Schritt m) durchgeführt wird.

14. Verfahren nach einem der Patentansprüche 1 bis 13,
**dadurch gekennzeichnet, dass** in Schritt i) Poly-SiGe als Opfer-Füllschicht (8) abgeschieden und planarisiert wird.

15. Verfahren nach einem der Patentansprüche 1 bis 14,
**dadurch gekennzeichnet, dass** in Schritt j) die Gate-Opferschicht (3M) nasschemisch selektiv zur Opfer-Füllschicht (8) und zum Spacer (7S) entfernt wird.

16. Verfahren nach einem der Patentansprüche 1 bis 14,
**dadurch gekennzeichnet, dass** in Schritt j) die zusätzlichen Schritte:
j1) Ausbilden einer Spacer-Zusatzschicht (9) und
j2) Entfernen eines Bodenbereichs der Spacer-Zusatzschicht (9) durchgeführt werden.

17. Verfahren nach Patentanspruch 16,
**dadurch gekennzeichnet, dass** in Schritt j1) eine Umwandlung der Spacer (7S) an ihrer Oberfläche mit atomarem Sauerstoff durchgeführt wird.

18. Verfahren nach einem der Patentansprüche 8 bis 17,
**dadurch gekennzeichnet, dass** in Schritt j) die Ätzstoppschicht (2A) zum Freilegen des Halbleitersubstrats (1) entfernt wird.

19. Verfahren nach einem der Patentansprüche 1 bis 18,
**dadurch gekennzeichnet, dass** die Schritte k) und l) zum Auffüllen der Gate-Aussparung mittels eines Damascene-Verfahrens realisiert werden.

20. Verfahren nach einem der Patentansprüche 1 bis 19,
**dadurch gekennzeichnet, dass** in Schritt k) Materialien mit hoher Dielektrizitätskonstante als Gate-Dielektrikum (10) verwendet werden.

21. Verfahren nach einem der Patentansprüche 1 bis 20,
**dadurch gekennzeichnet, dass** in Schritt l) Materialien mit hoher elektrischer Leitfähigkeit als Steuerschicht (11) verwendet werden.

22. Verfahren nach einem der Patentansprüche 1 bis 21,
**dadurch gekennzeichnet, dass** in Schritt n) ein Silizid-Verfahren durchgeführt wird.

23. Verfahren nach einem der Patentansprüche 1 bis 22,
**dadurch gekennzeichnet, dass** der Schritt n) nach Schritt h) durchgeführt wird.

24. Verfahren nach einem der Patentansprüche 1 bis 23,
**dadurch gekennzeichnet, dass** der Transistor ein PFET ist und die Steuerschicht (11) in-situ Bordotiertes Polysilizium und/oder eine dünne Schicht aus bor-dotiertem SiGe gefolgt von Polysilizium aufweist.

25. Verfahren nach einem der Patentansprüche 1 bis 23,
**dadurch gekennzeichnet, dass** der Transistor ein NFET ist und die Steuerschicht (11) in-situ Arsen oder Phosphor dotiertes Polysilizium aufweist.

## Claims

1. Method for fabricating a short channel field-effect transistor, comprising the steps of:
a) preparing a semiconductor substrate (1);
b) forming a first mask layer (2) at the surface of the semiconductor substrate (1);
c) lithographically patterning the first mask layer (2) to form a first mask (2BM) with substantially perpendicular side walls;
d) carrying out a chemical conversion of at least one side wall of the first mask (2BM) to form a sublithographic mask layer (3);
e) lithographically patterning the sublithographic mask layer (3) to form a sublithographic gate sacrificial layer (3M);
f) removing the first mask (2BM);
g) forming spacers (7S, 7S') at the side walls of the sublithographic gate sacrificial layer (3M);
h) forming connection regions (LDD) and/or source/drain regions (S, D) in the semiconductor substrate (1);
i) forming a sacrificial filling layer (8) to embed the sublithographic gate sacrificial layer (3M) and the spacers (7S);
j) removing the sublithographic gate sacrificial layer (3M) to form a gate recess;
k) forming a gate dielectric (10) in the gate recess;
l) forming a control layer (11) in the gate recess;
m) removing the sacrificial filling layer (8) in order to uncover the source/drain regions (S, D);
n) forming connection layers (12) for the source/drain regions (S, D); and
o) forming an insulation layer (13) in order to level a semiconductor surface.

2. Method according to Patent Claim 1, **characterized by** the further steps of:
e1) forming a protective layer (4) for the sublithographic mask layer (3) before step e); and
e2) removing the protective layer (4) after step e).

3. Method according to Patent Claim 2, **characterized in that** in step e1) the protective layer (4) is formed over the entire surface of the sublithographic mask layer (3) and is then caused to recede as far as the sublithographic mask layer (3).

4. Method according to one of Patent Claims 1 to 3, **characterized in that** in step d) a conformal conversion of the side walls of the first mask (2BM) is carried out over a thickness range of from 5 to 50 nanometers.

5. Method according to one of Patent Claims 1 to 4, **characterized in that** the first mask layer (2) includes a semiconductor material, and the chemical conversion in step d) represents an oxidation of the semiconductor material.

6. Method according to Patent Claim 5, **characterized in that** in step d) a wet oxidation with H₂ and O₂ is carried out.

7. Method according to one of Patent Claims 1 to 6, **characterized in that** in steps b) and c)
b1) a first resist layer is formed at the surface of the mask layer (2);
c1) the resist layer is lithographically patterned in order to form a first resist mask (RM); and
c2) the mask layer (2) is patterned using the first resist mask (RM).

8. Method according to one of Patent Claims 1 to 7, **characterized in that** the mask layer (2) includes an etching stop layer (2A), and in step e) a second resist mask (5) is used as etching mask.

9. Method according to Patent Claim 8, **characterized in that** the first mask layer (2) includes a polysilicon layer (2B) and a silicon nitride layer (2A).

10. Method according to one of Patent Claims 1 to 9, **characterized in that** before step g) a further protective layer (6) is formed at the surface of the semiconductor substrate (1), and in step m) this further protective layer (6) is removed again.

11. Method according to one of Patent Claims 1 to 10, **characterized in that** in step g) a conformal Si₃N₄ layer (7) is formed and etched anisotropically.

12. Method according to one of Patent Claims 1 to 11, **characterized in that** in step h) an ion implantation (I_{LDD}, I_{S/D}) with subsequent heat treatment is carried out.

13. Method according to one of Patent Claims 1 to 12, **characterized in that** step h) is carried out after step m).

14. Method according to one of Patent Claims 1 to 13, **characterized in that** in step i) poly-SiGe is deposited as sacrificial filling layer (8) and planarized.

15. Method according to one of Patent Claims 1 to 14, **characterized in that** in step j) the gate sacrificial layer (3M) is removed selectively with respect to the sacrificial filling layer (8) and with respect to the spacer (7S) by wet-chemical means.

16. Method according to one of Patent Claims 1 to 14, **characterized in that** in step j) the following additional steps are carried out:
j1) forming a spacer additional layer (9), and
j2) removing a base region of the spacer additional layer (9).

17. Method according to Patent Claim 16, **characterized in that** in step j1) conversion of the spacers (7S) is carried out at their surface using atomic oxygen.

18. Method according to one of Patent Claims 8 to 17, **characterized in that** in step j) the etching stop layer (2A) is removed in order to uncover the semiconductor substrate (1).

19. Method according to one of Patent Claims 1 to 18, **characterized in that** steps k) and l) for filling the gate recess are realized by means of a Damascene process.

20. Method according to one of Patent Claims 1 to 19, **characterized in that** in step k) materials with a high dielectric constant are used as gate dielectric (10).

21. Method according to one of Patent Claims 1 to 20, **characterized in that** in step l) materials with a high electrical conductivity are used as control layer (11).

22. Method according to one of Patent Claims 1 to 21, **characterized in that** in step n) a silicide process is carried out.

23. Method according to one of Patent Claims 1 to 22, **characterized in that** step n) is carried out after step h).

24. Method according to one of Patent Claims 1 to 23, **characterized in that** the transistor is a PFET and the control layer (11) includes in-situ boron-doped polysilicon and/or a thin film of boron-doped SiGe followed by polysilicon.

25. Method according to one of Patent Claims 1 to 23, **characterized in that** the transistor is an NFET and the control layer (11) includes in-situ arsenic- or phosphorus-doped polysilicon.

## Revendications

1. Procédé de production d'un transistor à effet de champ à canal court, comprenant les stades dans lesquels:
a) on prépare un substrat (1) semi-conducteur ;
b) on forme une première couche (2) de masque à la surface du substrat (1) semi-conducteur ;
c) on structure par lithographie la première couche (2) de masque pour former un premier masque (2BM) ayant des parois latérales sensiblement verticales ;
d) on effectue une transformation chimique d'au moins une paroi latérale du premier masque (2BM) pour former une couche (3) de masque sous-lithographique ;
e) on structure par lithographie la couche (3) de masque sous-lithographique pour former une couche (3M) sacrificielle de grille sous-lithographique ;
f) on élimine le premier masque (2BM) ;
g) on forme des espaceurs (7S, 7S') sur les parois latérales de la couche (3M) sacrificielle de grille sous-lithographique ;
h) on forme des zones (LDD) de borne et/ou des zones (S, D) de source/drain dans le substrat (1) semi-conducteur ;
i) on forme une couche (8) de remplissage sacrificielle pour incorporer la couche (3M) sacrificielle de grille sous-lithographique et les espaceurs (7S) ;
j) on élimine la couche (3M) sacrificielle de grille sous-lithographique pour former un évidement de grille ;
k) on forme un diélectrique (10) de grille dans l'évidement de grille ;
l) on forme une couche (11) de commande dans l'évidement de grille ;
m) on élimine la couche (8) de remplissage sacrificielle pour mettre à nu les zones (S, D) de source/drain ;
n) on forme des couches (12) de borne pour les zones (S, D) de source/drain ; et
o) on forme une couche (13) isolante pour aplanir une surface de semi-conducteur.

2. Procédé suivant la revendication 1,
**caractérisé par** les stades supplémentaires, dans lesquels :
e1) on forme une couche (4) de protection de la couche (3) de masque sous-lithographique avant le stade e); et
e2) on élimine la couche (4) de protection après le stade e).

3. Procédé suivant la revendication 2,
**caractérisé en ce qu'**au stade e1) on forme la couche (4) de protection sur toute la surface sur la couche (3) de masque sous-lithographique et ensuite on l'élimine jusqu'à la couche (3) de masque sous-lithographique.

4. Procédé suivant l'une des revendications 1 à 3,
**caractérisé en ce qu'**au stade d) on effectue une transformation conforme des parois latérales du premier masque (2BM) dans une zone d'une épaisseur de 5 à 50 nanomètres.

5. Procédé suivant l'une des revendications 1 à 4,
**caractérisé en ce que** la première couche (2) de masque a un matériau semi-conducteur et la transformation chimique au stade d) constitue une oxydation du matériau semi-conducteur.

6. Procédé suivant la revendication 5,
**caractérisé en ce que** l'on effectue au stade d) une oxydation en voie humide par H₂ et O₂.

7. Procédé suivant l'une des revendications 1 à 6,
**caractérisé en ce qu'**aux stades b) et c)
b1) on forme une première couche de réserve à la surface de la couche (2) de masque ;
c1) on structure par lithographie la couche de réserve pour former un premier masque (RM) de réserve ; et
c2) on effectue une structuration de la couche (2) de masque en utilisant le premier masque (RM) de réserve.

8. Procédé suivant l'une des revendications 1 à 7,
**caractérisé en ce que** la première couche (2) de masque a une couche (2A) d'arrêt d'attaque et au stade e) on utilise un deuxième masque (5) de réserve comme masque d'attaque.

9. Procédé suivant la revendication 8,
**caractérisé en ce que** la première couche (2) de masque a une couche (2B) de polysilicium et une couche (2A) de nitrure de silicium.

10. Procédé suivant l'une des revendications 1 à 9,
**caractérisé en ce qu'**avant le stade g) on forme une autre couche (6) de protection à la surface du substrat (1) semi-conducteur et au stade m) on élimine à nouveau cette autre couche (6) de protection.

11. Procédé suivant l'une des revendications 1 à 10,
**caractérisé en ce qu'**au stade g) on forme une couche (7) conforme en Si₃N₄ et on l'attaque de façon anisotrope.

12. Procédé suivant l'une des revendications 1 à 11,
**caractérisé en ce qu'**au stade h) on effectue une implantation (I_{LDD}, I_{S/D}) d'ions en faisant suivre d'un traitement thermique.

13. Procédé suivant l'une des revendications 1 à 12,
**caractérisé en ce que** l'on effectue le stade h) après le stade m).

14. Procédé suivant l'une des revendications 1 à 13,
**caractérisé en ce qu'**au stade i) on dépose du poly-SiGe comme couche (8) de remplissage sacrificielle et on la planarise.

15. Procédé suivant l'une des revendications 1 à 14,
**caractérisé en ce qu'**au stade j) on élimine la couche (3M) sacrificielle de grille chimiquement en voie humide sélectivement par un rapport à la couche (8) de remplissage sacrificielle et par rapport à l'espaceur (7S).

16. Procédé suivant l'une des revendications 1 à 14,
**caractérisé en ce qu'**au stade j) on effectue les stades supplémentaires :
j1) on forme une couche (9) supplémentaire d'espaceur et
j2) on élimine une zone de fond de la couche (9) supplémentaire d'espaceur.

17. Procédé suivant la revendication 16,
**caractérisé en ce qu'**au stade j1) on effectue une transformation de l'espaceur (7S) sur sa surface par de l'oxygène atomique.

18. Procédé suivant l'une des revendications 1 à 17,
**caractérisé en ce qu'**au stade j) on élimine la couche (2A) d'arrêt d'attaque pour mettre à nu le substrat (1) semi-conducteur.

19. Procédé suivant l'une des revendications 1 à 18,
**caractérisé en ce que** l'on réaliser les stades k) et l) de remplissage de l'évidement de grille au moyen d'un procédé Damascène.

20. Procédé suivant l'une des revendications 1 à 19,
**caractérisé en ce qu'**au stade k) on utilise des matériaux ayant une grande constante diélectrique comme diélectrique (10) de grille.

21. Procédé suivant l'une des revendications 1 à 20,
**caractérisé en ce qu'**au stade l) on utilise des matériaux ayant une grande conductivité électrique comme couche (11) de commande.

22. Procédé suivant l'une des revendications 1 à 21,
**caractérisé en ce qu'**au stade n) on effectue un procédé au siliciure.

23. Procédé suivant l'une des revendications 1 à 22,
**caractérisé en ce que** l'on effectue le stade n) après le stade h).

24. Procédé suivant l'une des revendications 1 à 23,
**caractérisé en ce que** le transistor est un PFET et la couche (1) de commande comprend du polysilicium dopé in situ par du bore et/ou une couche mince de SiGe dopé par du bore suivi de polysilicium.

25. Procédé suivant l'une des revendications 1 à 23,
**caractérisé en ce que** le transistor est un NFET et la couche (11) de commande comporte du polysilicium dopé in situ par de l'arsenic ou par du phosphore.
